# EUROPEAN PATENT APPLICATION

(11) **EP 1 648 039 A1**
(43) Date of publication of application: **19.04.2006**
(21) Application number: 03741504.9
(22) Date of filing: 18.07.2003
(51) Int. Cl.: H01L 43/08, H01L 43/12, G01R 33/09, G11B 5/39, H01F 10/32

(54) **CCP MAGNETORESISTANCE ELEMENT, METHOD FOR MANUFACTURING SAME, MAGNETIC HEAD AND MAGNETIC STORAGE**

(71) Applicant: FUJITSU LIMITED, Kawasaki-shi, Kanagawa 211-8588 (JP)
(72) Inventor: FUKAMICHI, Kazuaki, Sendai-shi, Miyagi 982-0213 (JP); UMETSU, Rie, Sendai-shi, Miyagi 980-0004 (JP); TANAKA, Atsushi, c/o Fujitsu Limited, Kawasaki-shi, Kanagawa 211-8588 (JP)
(74) Representative: Sunderland, James Harry
(86) International application number: PCT/JP2003/009187
(87) International publication number: WO 2005/008799

(57) **Abstract**

In a CPP magneto-resistive element, an antiferromagnetic layer (26) for fixing the magnetization of a fixed magnetic layer (28) is formed including an alloy of Mn and at least one element of a group including Pd, Pt, Ni, Ir, and Rh, and is provided with a specific resistance ranging from 10 *µ* Ω · cm to 150 µΩ · cm at a temperature of 300K. The material of the antiferromagnetic layer may include an alloy of Mn and at least one element of a group including Pd, Pt, Ni, and Ir, in which the Mn content of the antiferromagnetic layer ranges from 45 atom% to 52 atom%. In MnRh, the Rh content may range from 15 atom% to 30 atom%. In MnIr, the Ir content may range from 20 atom% to 35 atom%. Thus, a CPP magneto-resistive element is provided having high sensitivity and being suitable for high density recording by improving resistance change rate by reducing the resistance value of parasitic resistance.

## Description

### BACKGROUND OF THE INVENTION

### 1. Field of the Invention

The present invention relates to a magnetic sensor, for example, a magneto-resistive element for reproducing information in a magnetic memory apparatus, and more particularly to a magneto-resistive element having a CPP (Current Perpendicular to Plane) structure that applies sense current in the lamination direction by using a spin valve film or a magnetic tunnel junction film.

### 2. Description of the Related Art

Along with the rapid growth of information networks such as the Internet, the demand for memory apparatuses with greater capacity is increasing. For example, large capacity memory apparatuses such as a hard disk apparatuses show a significant improvement of recording density that is increasing at an annual rate of 60% to 100%. One factor for this technological improvement is the development of a high sensitivity spin valve magneto-resistive element which is used as a magnetic sensing element for reproducing a magnetic head.

The conventional spin valve magneto-resistive element includes a CIP (Current In-Plane) structure, that is, a structure that allows a sense current to be applied in an in-plane direction of a spin valve film including a fixed magnetic layer interposed between a free magnetic layer and a non-magnetic layer in which the magnetization direction changes according to the magnetic field emanating from a magnetic recording medium. In the spin valve film, the scattering of the electrons changes according to the magnetization angle of the free magnetic layer and the fixed magnetic layer, to thereby change the resistance of the spin valve film. The current spin valve magneto-resistive element having the CIP structure has achieved a resistance change rate of approximately 5% (changed amount of resistance/ entire resistance of spin valve magneto-resistive element) and a recording density of approximately 50 Gbit/in².

In order to achieve the next generation recording density in the 100 Gbit/in² range, further improvement of track density and linear recording density are required. However, in the spin valve magneto-resistive element having the CIP structure, an attempt to improve track density by reducing the core width results in the reduction of reproduction output relative to the reduction of core width. Furthermore, in order to reduce the length of the read gap for improving linear recording density, it is necessary to reduce the thickness of the insulation films formed above and beneath the spin valve magneto-resistive element comprising the read gap. However, the reduction of the thicknesses of the insulation films causes leakage that results in insufficient supply of sense current. This causes a problem of reproduction output loss.

Meanwhile, in a magneto-resistive element having a CPP (Current Perpendicular to Plane) structure, sense current is applied in a direction perpendicular to the plane of the spin valve film, such that the above-described problems caused for improving recording density can be prevented. Accordingly, one significant objective for the magneto-resistive element having a CPP structure is to increase the resistance change rate and improve output.

In order to achieve the objective, a technology of reducing an element to a finer size is proposed. This method takes advantage of a property in which resistance change increases as the cross-sectional area of an element becomes smaller. As for other proposed technologies for increasing the amount of change of resistance, there is a structure having a double layer of spin valve films for obtaining a double amount of resistance change or a structure having an extremely thin Cu film inserted onto a ferromagnetic layer.

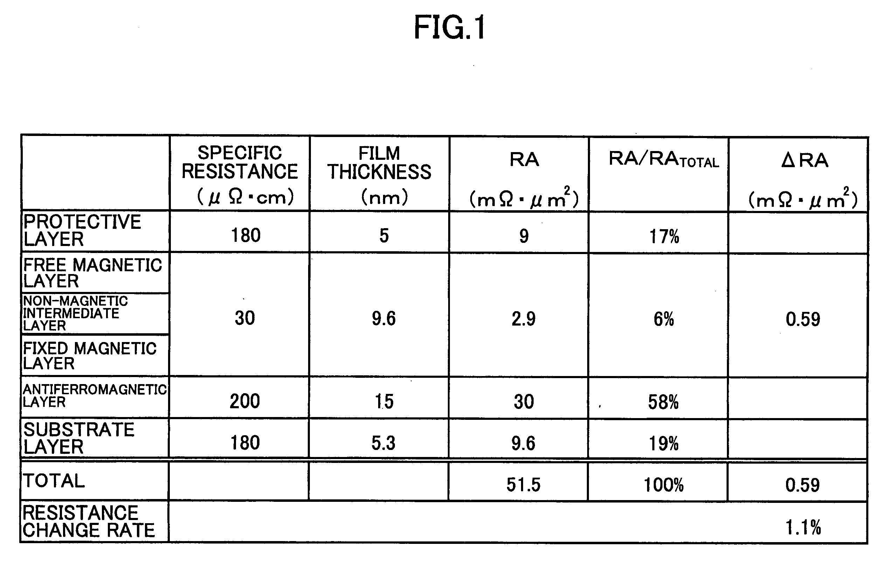

With these structures, however, the resistance change rate of the magneto-resistive element having the CPP structure 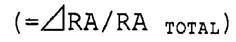 is approximately 1% in a case where there is only one spin valve film, as shown in Fig.1. It is to be noted that "RA" represents the resistance for a single unit of a cross-sectional area that is obtained by multiplying the film thickness with resistivity, "RA _{TOTAL}" represents the entire resistance of the magneto-resistive element, and 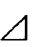 RA" represents the change amount of the resistance (resistance change amount) of the spin valve film. The "RA _{TOTAL}" is a sum of the resistance including not only the resistance of the spin valve film but also the respective resistance of the buffer layer, the antiferromagnetic layer, and a cap layer. Since the antiferromagnetic layer, in particular, has a large resistivity of 200 *µ* Ω·cm and a large thickness of 15 nm, the resistance of antiferromagnetic layer is 58% of the entire resistance "RA _{TOTAL}". Since the resistance of the antiferromagnetic layer is a so-called parasitic resistance which does not contribute to the amount of resistance change, the loss of resistance change rate becomes greater as resistance of the antiferromagnetic layer increases. Patent Document 1 Japanese Laid-Open Patent Application No.2002-176211

### SUMMARY OF THE INVENTION

It is a general object of the present invention to provide a CPP magneto-resistive element, a method of manufacturing the CPP magneto-resistive element, a magnetic head including the CPP magneto-resistive element, and a magnetic memory apparatus including the CPP magneto-resistive element that substantially obviate one or more of the problems caused by the limitations and disadvantages of the

### related art.

A more specific object of the present invention is to provide a CPP magneto-resistive element having high sensitivity and being suitable for high density recording by improving resistance change rate by reducing the resistance value of parasitic resistance, a method of manufacturing the CPP magneto-resistive element, a magnetic head including the CPP magneto-resistive element, and a magnetic memory apparatus including the CPP magneto-resistive element.

According to one aspect of the present invention, there is provided a CPP magneto-resistive element including a substrate, and an antiferromagnetic layer, a fixed magnetic layer, a non-magnetic intermediate layer, and a free magnetic layer that are sequentially formed on the substrate, in which the antiferromagnetic layer includes an alloy of Mn and at least one element of a group including Pd, Pt, Ni, Ir, and Rh, and which the specific resistance of the antiferromagnetic layer ranges from 10 *µ* Ω · cm to 150 *µ* Ω · cm at a temperature of 300K.

With the present invention, the antiferromagnetic layer of a CPP (Current Perpendicular to Plane) magneto-resistive element including a substrate, and an antiferromagnetic layer, a fixed magnetic layer, a non-magnetic intermediate layer, and a free magnetic layer that are sequentially formed on the substrate is provided with an alloy of Mn and at least one element of a group including Pd, Pt, Ni, Ir, and Rh, and is set with a specific resistance ranging from 10 *µ* Ω · cm to 150 µΩ · cm at a temperature of 300K. By reducing the specific resistance of the antiferromagnetic layer having a thickness greater than those of the layers, the resistance of the CPP magneto-resistive element can be reduced and the resistance change rate can be improved.

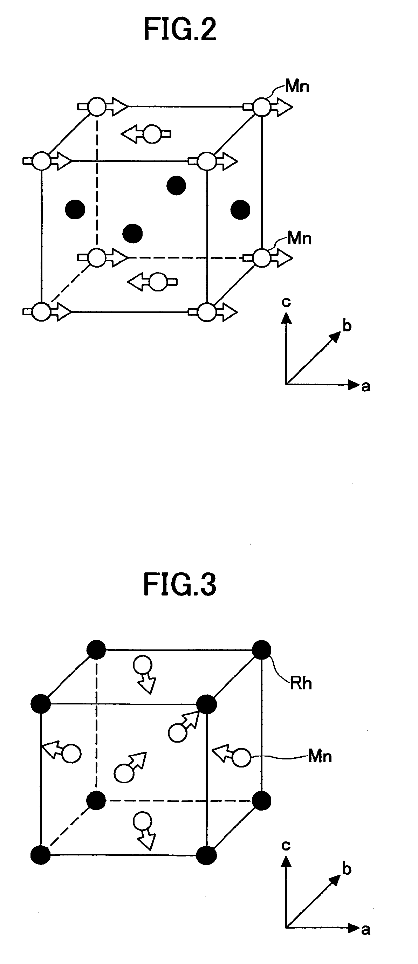

The antiferromagnetic layer may have a crystal structure including a CuAu I type ordered structure. The specific resistance can be further reduced by improving the ordered structure of the antiferromagnetic layer and making its atom arrangement highly uniform. Here, the CuAu I type ordered structure has an fct (face-centered tetragonal lattice) structure, in which, for example, either one of the Mn atoms (illustrated as "O") or the Pd, Pt, Ni or Ir atoms (illustrated as "●") occupy the (001) plane and have lattice points disposed also at the face center and the other one of the atoms occupy the (002) plane as shown in Fig.2. Furthermore, the magnetization of the Mn atoms is set so that the Mn atoms at the face center are directed in an anti-parallel manner as shown by the arrows.

The antiferromagnetic layer may include an alloy of Mn and at least one element of a group including Pd, Pt, Ni, and Ir, in which the Mn content of the antiferromagnetic layer may range from 45 atom% to 52 atom%. The Mn element alloy having the CuAu I type ordered structure can attain lowest specific resistance by having its Mn content range from 45 atom% to 52 atom%.

The antiferromagnetic layer may include MnRh, in which the Rh content may range from 15 atom% to 30 atom%. Since the MnRh alloy exhibits a low specific resistance in this range, its resistance can be reduced. The MnRh alloy is formed with an ordered structure alloy having a CuAu II type ordered structure, in which Mn₃Rh, that is, its Rh content ranges from 15 atom% to 30 atom% (mainly 25 atom%). The CuAu II type ordered structure has an fcc (face-centered cubical lattice) structure, in which, for example, the atoms forming the two element alloy (Mn atoms illustrated as "O", Rh atoms illustrated as "●") occupy the face center positions as shown in Fig.3. Furthermore, the magnetization of the Mn atoms is set so that the formation of the ordered structure can be promoted and a highly uniform atom arrangement can be obtained by having the Rh content in the (111) plane range from 15 atom% to 30 atom%. Accordingly, the specific resistance can be reduced.

The antiferromagnetic layer may include MnIr, in which the Ir content may range from 20 atom% to 35 atom%. Since the MnIr alloy exhibits a low specific resistance in this range, its resistance can be reduced. Since the MnIr alloy is formed with an ordered structure alloy having Mn₃Ir, that is, its Ir content mainly of 25 atom%, the formation of the ordered structure can be promoted and a highly uniform atom arrangement can be obtained. Accordingly, the specific resistance can be reduced.

Furthermore, another antiferromagnetic layer may be provided between the antiferromagnetic layer and the fixed magnetic layer, in which the other antiferromagnetic layer may include the same materials as the antiferromagnetic layer and have a specific resistance higher than that of the antiferromagnetic layer.

According to another aspect of the present invention, there are provided a magnetic head including one of the foregoing CPP magneto-resistive elements, and a magnetic memory apparatus having said magnetic head and a magnetic recording medium.

With the present invention, a magnetic head and a magnetic memory apparatus having high sensitivity and high density recording applicability can be obtained since one of the foregoing CPP magneto-resistive elements has a high resistance change rate.

According to another aspect of the present invention, there is provided a method of manufacturing a CPP magneto-resistive element including a substrate, and an antiferromagnetic layer, a fixed magnetic layer, a non-magnetic intermediate layer, and a free magnetic layer that are sequentially formed on the substrate, the method including the steps of forming the antiferromagnetic layer on the substrate, forming the fixed magnetic layer on the antiferromagnetic layer, and executing an ordered structure thermal process by heating the antiferromagnetic layer and forming the antiferromagnetic layer into an ordered structure between the step of forming the antiferromagnetic layer and the step of forming the fixed magnetic layer.

With the present invention, the atoms in the antiferromagnetic layer can uniformly form an ordered structure by performing the heating process before forming the fixed magnetic layer on the antiferromagnetic layer. Thereby, the antiferromagnetic layer can attain an improved ordered structure, and the specific resistance can be reduced by the formation of the ordered structure. Furthermore, the heat from the ordered structure thermal process does not affect the junction part including the fixed magnetic layer, the non-magnetic intermediate layer, and the free magnetic layer. Accordingly, problems such as deterioration of resistance change which changes in response to applied magnetic field will not be caused. As a result, the entire resistance can be reduced, and the resistance change rate can be improved since resistance change is uniform.

Furthermore, a step of etching the surface of the antiferromagnetic layer may be included between the step of executing the ordered structure thermal process and the step of forming the fixed magnetic layer. Since the ordered structure thermal process may cause changes such as oxidation at the surface of the antiferromagnetic layer, the etching serves to activate the surface of the antiferromagnetic layer. Thereby, the crystal match with respect to the fixed magnetic layer formed thereon can be improved. Thus, the crystallinity of the initial growth layer of the fixed magnetic layer can be improved. As a result, the magnetization of the fixed magnetic layer can be sufficiently fixed by the exchange interaction generated between the antiferromagnetic layer and the fixed magnetic layer.

Furthermore, another antiferromagnetic layer, which includes the same materials as the antiferromagnetic layer, may be formed on the antiferromagnetic layer after the etching step. By forming the other antiferromagnetic layer having the same materials as the antiferromagnetic layer improves the crystal match between the antiferromagnetic layer and the other antiferromagnetic layer as well as the crystal match between the other antiferromagnetic layer and the fixed magnetic layer. Thereby, the exchange interaction between the antiferromagnetic layer and the fixed magnetic layer can be further improved.

### BRIEF DESCRIPTION OF THE DRAWINGS

Fig.1 is a drawing showing specific resistance and resistance change rate according to a conventional magneto-resistive element having a CPP structure;
Fig.2 is a drawing showing a crystal structure of a CuAu-I superstructure;
Fig.3 is a drawing showing a crystal structure of a CuAu-II superstructure;
Fig.4 is a drawing showing a configuration of a medium facing plane of a complex type magnetic head;
Fig.5 is a drawing showing a GMR film included in a magneto-resistive element according to a first embodiment of the present invention;
Fig.6 is a drawing showing the properties of a Mn-TM alloy and a MnRh alloy;
Fig.7 is a drawing showing temperature change and specific resistance of a MnPt alloy;
Fig.8 is a drawing showing the relation between specific resistance and composition of a MnPt alloy at 300K;
Figs.9A and 9B are drawings showing temperature change and specific resistance of a MnPd alloy;
Fig.10 is a drawing showing the relation between specific resistance and composition of a MnPd alloy at 300K;
Figs.11A and 11B are drawings showing temperature change and specific resistance of a MnNi alloy;
Fig.12 is a drawing showing the relation between specific resistance and composition of a MnNi alloy at 300K;
Fig.13 is a drawing showing temperature change and specific resistance of a MnIr alloy;
Fig.14 is a drawing showing the relation between specific resistance and composition of a MnIr alloy at 300K;
Fig.15 is a drawing showing temperature change and specific resistance of a MnRh alloy in a case where the RH amount is around 25 atom%;
Fig.16 is a drawing showing the relation between specific resistance and composition of a MnRh alloy and a MnIr alloy (Rh amount, Ir amount: around 25 atom%) at 300K;
Fig.17 is a drawing showing temperature change and specific resistance of a MnIr alloy in a case where the Ir amount is around 25 atom%;
Figs.18A-18F are tables showing figures of the relation between specific resistance and composition of a Mn-TM alloy and a MnRh alloy at 300K;
Fig.19 is a drawing showing a process of manufacturing a magneto-resistive element according to the first embodiment of the present invention (Part 1);
Fig.20 is a drawing showing a process of manufacturing a magneto-resistive element according to the first embodiment of the present invention (Part 2)
Fig.21 is a drawing showing a process of manufacturing a magneto-resistive element according to the first embodiment of the present invention (Part 3);
Fig.22 is a drawing showing a process of manufacturing a magneto-resistive element according to the first embodiment of the present invention (Part 4);
Fig.23 is a drawing showing a process of manufacturing a magneto-resistive element according to the first embodiment of the present invention (Part 5);
Fig.24 is a drawing showing a process of manufacturing a magneto-resistive element according to the first embodiment of the present invention (Part 6);
Fig.25 is a drawing showing a GMR film included in a modified example of a magneto-resistive element according to the first embodiment of the present invention;
Fig.26 is a drawing showing a process of manufacturing a modified example of a magneto-resistive element according to the first embodiment of the present invention (Part 1);
Fig.27 is a drawing showing a process of manufacturing a modified example of a magneto-resistive element according to the first embodiment of the present invention (Part 2);
Fig.28 is a drawing showing a TMR film included in a magneto-resistive element according to the second embodiment of the present invention;
Fig.29 is a cross-sectional view showing a main portion of a magnetic memory apparatus according to the third embodiment of the present invention; and
Fig.30 is a plan view showing the main portion of the magnetic memory apparatus shown in Fig.29.

### [Description of Reference Numerals]

10, 67 ··· complex type magnetic head
11, 67A ··· induction type recording element
12, 67B ··· magneto-resistive element
20, 40 ··· GMR film
25 ··· substrate layer
26 ··· antiferromagnetic layer, first antiferromagnetic layer
28 ··· fixed magnetic layer
29 ··· non-magnetic intermediate layer
30 ··· free magnetic layer
31 ··· protective layer
33 ··· antiferromagnetic layer in a deposited state
41 ··· second antiferromagnetic layer
50 ··· TMR film
51 ··· non-magnetic insulation layer
60 ··· magnetic memory apparatus

### DESCRIPTION OF THE PREFERRED EMBODIMENTS

Embodiments of the present invention are described below with reference to the drawings.

### [First Embodiment]

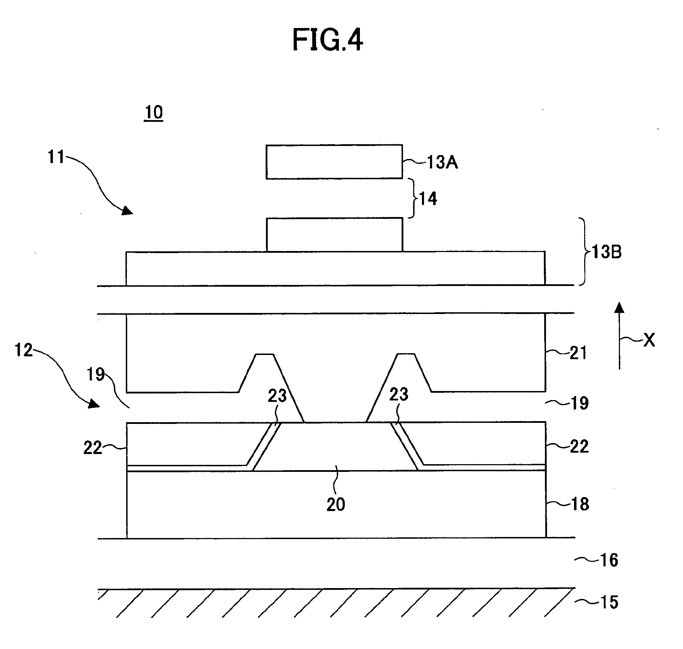

Fig.4 is a drawing showing a configuration of a medium facing surface of a complex magnetic head including an induction type recording element and a magneto-resistive element for performing recording and reproduction. In Fig.4, the rotation direction of the medium is the direction indicated by arrow X.

A complex type magnetic head 10 shown in Fig.4 has a magneto-resistive element 12 formed on a flat ceramic substrate 15 (including Al₂O₃-TiC (AlTiC) and serving as a substrate of a head slider) and an induction type recording element 11 having an alumina film therebetween, in which these are covered by an insulation member such as alumina.

The complex magnetic head 10 includes the induction type recording element 11 and the magneto-resistive element 12. The induction type recording element 11, which is situated on the downstream side of the medium rotation direction, performs recording. The magneto-resistive element 12, which is situated on the upstream side of the medium rotation direction, has a CPP type structure. The complex type magnetic head 10 uses the magnetic field leaking from a gap between an upper magnetic pole 13A and a lower magnetic pole 13B of the induction type recording element 11 to record information to a magnetic recording medium (not shown) facing the complex type magnetic head 10. Furthermore, the complex type magnetic head 10 detects information recorded to the magnetic recording medium by having the magneto-resistive element 12 detect leaking magnetic field corresponding to the recorded information as a change(s) of resistance.

The induction type recording element 11 includes, for example, the upper magnetic pole 13A having a width corresponding to the track width of the magnetic recording medium, the lower magnetic pole 13B sandwiching a recording gap layer 14 with respect to the upper magnetic pole 13B, a yoke (not shown) for connecting the upper and lower magnetic poles 13A, 13B, and a coil (not shown) wound around the yoke. The upper magnetic pole 13A, the lower magnetic pole 13B, and the yoke are formed of a soft magnetic material and include a material having large saturation magnetic flux density for obtaining sufficient record magnetic field, such as Ni₈₀Fe₂₀, CoZrNb, FeN, FeSiN, FeCo alloy.

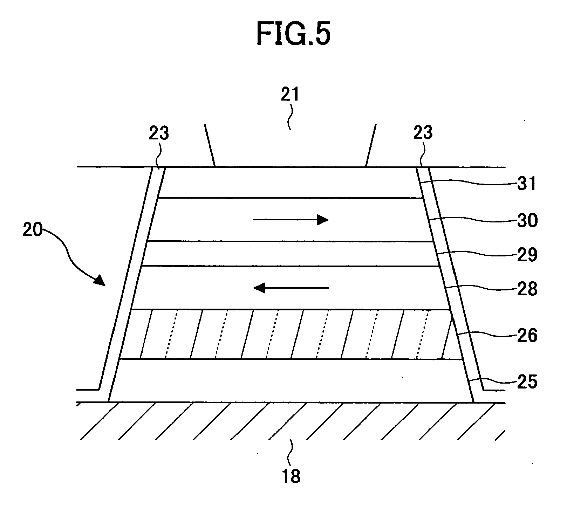

The magneto-resistive element 12, being formed on an alumina film 16 applied on the surface of the ceramic substrate 15, has a sequentially layered configuration including a lower electrode 18, a GMR film 20, an alumina film 19, and an upper electrode 21 sandwiching the alumina film 19. The GMR film 20 has magnetic domain control films 22 formed on both of its sides via an insulation film 23 having a film thickness of approximately 10 nm or less. The sense current used for detecting resistance change is applied, for example, from the upper electrode 21 to the lower electrode 18 via the GMR film 20. The fixed magnetic layer and the free magnetic layer (shown in Fig.5), which are soft magnetic material layers included in the GMR film 20, are each formed as single magnetic domains so as to prevent generation of barkhausen noise. In addition to a function of providing a flow path of sense current, the upper electrode 21 and the lower electrode 18 also provide a function of a magnetic shield. Therefore, the upper electrode 21 and the lower electrode 18 are formed of a soft magnetic alloy material such as NiFe, CoFe.

Fig.5 is a drawing showing a GMR film included in a magneto-resistive element according to an embodiment of the present invention. In Fig.5, the GMR 20 has a single spin valve structure having a sequentially layered configuration including a substrate layer 25, an antiferromagnetic layer 26, a fixed magnetic layer 28, a non-magnetic intermediate layer 29, a free magnetic layer 30, and a protective layer 31.

The substrate layer 25 is formed on the lower electrode (as shown in Fig.4) by employing, for example, a sputtering method. The substrate layer 25 has, for example, a Ta film of 5 nm and a NiFe film of 5 nm which are formed in this order. The preferable amount of Fe contained in the NiFe film ranges from 17 atom% to 25 atom%. Accordingly, easier epitaxial growth can be achieved for the antiferromagnetic layer 26 formed on the (111) crystal plane in the crystal growth direction of the NiFe film and an equivalent crystal plane thereof.

The anitferromagnetic layer 26 (described in further detail below) is formed on the surface of the substrate layer 25 by employing, for example, a sputtering method, a vapor deposition method, a CVD method. The antiferromagnetic layer 26 includes, for example, a Mn-TM alloy (TM = at least one of Pt, Pd, Ni, and Ir) or a MnRh alloy which have a thickness of 5 nm to 30 nm (preferably 10 nm to 20 nm). After the alloy is deposited by employing, for example, a sputtering method, the alloy is subjected to a thermal process which is performed in a higher temperature and for a longer time than a conventional thermal process (hereinafter referred to as "ordered structure thermal process"). For example, by performing the thermal process for three days in a temperature of 800 °C, an ordered alloy structure having an antiferromagnetic property and a significantly reduced specific resistance (for example, reduced to a specific resistance that is no greater than 150 *µ* Ωcm) can be obtained.

Furthermore, after performing the ordered structure thermal process and forming the protective layer 31, the antiferromagnetic layer 26, while being applied with a magnetic field, is subjected to a thermal process which is performed in a temperature lower than that of the ordered structure thermal process (for example, in a temperature of 260 °C). Thereby, uniaxial anisotropy is induced. Accordingly, the exchange interaction between the antiferromagnetic layer 26 and the fixed magnetic layer 28 formed thereon created so that the magnetization direction of the fixed magnetic layer 28 can be fixed.

The fixed magnetic layer 28 includes, for example, Co, Fe, Ni, and a soft magnetic material containing these elements (for example, a material including Ni₈₀Fe₂₀ or Co₉₀Fe₁₀ may be used) having a thickness of 1 nm to 30 nm. The fixed magnetic layer 28 may be a configuration having layers of these materials. The fixed magnetic layer 28 has its magnetization direction fixed by the exchange interaction with the antiferromagnetic layer 26 provided therebelow.

The non-magnetic intermediate layer 29 includes, for example, a conductive material having a thickness of 1.5 nm to 4.0 nm (formed employing a sputtering method). The non-magnetic intermediate layer 29 includes, for example, a Cu film or an Al film.

The free magnetic layer 30 includes, for example, Co, Fe, Ni, and a soft magnetic material containing these elements (for example, a material including Ni₈₀Fe₂₀, Co₉₀Fe₁₀, or Co₇₈Fe₂₀B₂ may be used) having a thickness of 1 nm to 30 nm (formed on the surface of the non-magnetic intermediate layer 29 by employing a sputtering method). The free magnetic layer 30 may be a configuration having layers of these materials. The magnetization of the free magnetic layer 30 is oriented in an in-plane direction and changes orientation according to the direction of the magnetic field leaking from the magnetic recording medium. Accordingly, the resistance of the layered configuration including the fixed magnetic layer 28, the non-magnetic intermediate layer 29, and the free magnetic layer 30 changes in accordance with the angle formed by the magnetization of the free magnetic layer 30 and the magnetization of the fixed magnetic layer 28.

The protective layer 31 is formed on the surface of the free magnetic layer 30 by employing a sputtering method, for example. For example, the protective layer 31 may have a sequentially layered configuration, such as a layered configuration of a Ta layer and a Ru layer (each having a thickness of 5 nm) or a layered configuration of a Cu layer and a Ru layer (each having a thickness of 5nm). More specifically, the Cu layer included in the protective layer 31 may have a thickness of 1 nm to 5 nm. The Cu layer prevents oxidation of the free magnetic layer 30 during the thermal process of the GMR film 20 and also serves to improve resistance change by forming a magnetic/non-magnetic interface with respect to the free magnetic layer 30. The Ru layer may be, for example, a non-magnetic metal (e.g. Au, Al, W) having a thickness of 5 nm to 30 nm. This prevents the GMR film 20 from being oxidated during the thermal process of the antiferromagnetic layer. Thereby, the GMR film 20 is attained.

Next, the antiferromagnetic layer 26 is described in detail. The antiferromagnetic layer 26 includes, for example, a Mn-TM alloy (TM = at least one of Pt, Pd, Ni, and Ir) or a MnRh alloy which have a thickness of 5 nm to 30 nm (preferably 10 nm to 20 nm). The inventors of the present invention found that Mn-TM alloy (TM = at least one of Pt, Pd, Ni, and Ir) exhibits a significant reduction of specific resistance under a predetermined thermal process condition (described below) in a case where the amount of TM alloy is around 50 atom% and in a case where the amount of Rh in MnRh and the amount of Ir in MnIr is around 25 atom%. The Mn-TM alloy has a crystal structure of a CuAu I type ordered structure where its composition is 50 atom% Mn and 50 atom% TM in an equilibrium state. Furthermore, the MnRh alloy and the MnIr alloy has a crystal structure of a CuAu II type ordered structure where its composition is 75 atom% Mn and 25 atom% Rh or Ir. Forming such ordered structure enables an antiferromagnetic layer to attain a specific resistance that is reduced to a level which could not be achieved by a conventional antiferromagnetic layer.

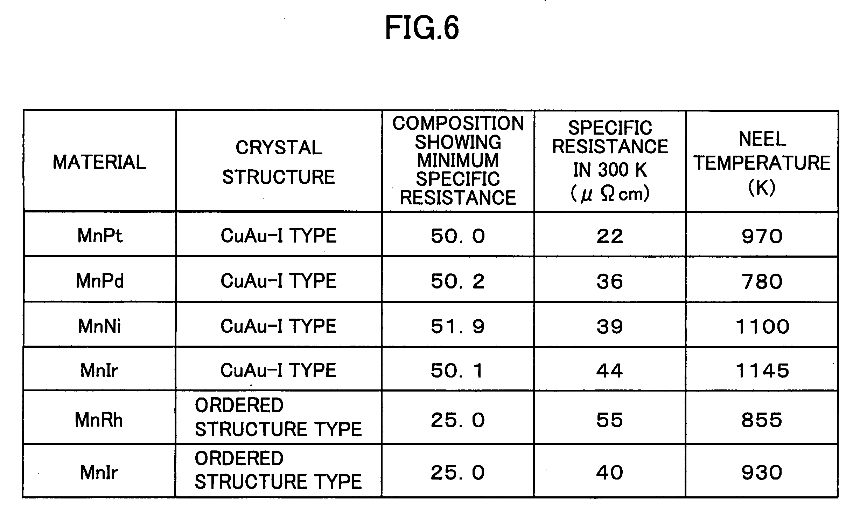

Fig.6 is a drawing showing the properties of a Mn-TM alloy and a MnRh alloy. It is to be noted that the properties shown by each alloy in Figs.6 to 17 are obtained by vacuum sealing (degree of vacuum ranging from 10⁻⁴ Pa to 10⁻³ Pa) a polycrystalline ingot (measurements: 3 mm X 3 mm X 10 mm) of each alloy inside a quartz glass tube and performing the ordered structure thermal process for three days in a temperature of 800 °C. It is to be noted that the lowering of temperature is performed by natural cooling in the furnace. Furthermore, the measuring of specific resistance is performed by a four terminal method in a vacuum atmosphere inside a vacuum apparatus where the degree of vacuum ranges from 10⁻⁴ Pa to 10⁻³ Pa. The changes of specific resistance are measured in a case where temperature is raised from room temperature to 1100 K and in a case where temperature is lowered. In a case of a MnPd alloy and a MnNi alloy, the specific resistance is measured to 4.2 K.

In Fig.6, the Mn-TM alloy shows that specific resistance is minimum value when its composition is around 50% atom Mn and 50% atom TM in a temperature of 300 K. Furthermore, it is shown that, although the minimum value of specific resistance is different depending on the element of TM, the minimum value of specific resistance ranges from 22 *µ* Ω · cm to 60 *µ* Ω · cm. Furthermore, since specific resistance is significantly reduced around a composition of 50%atom Mn and 50% atom TM, it is considered that specific resistance can be reduced to 10 *µ* Ω · cm by rigorously selecting the composition.

The MnRh alloy and the MnIr alloy shows that specific resistance is minimum value when its composition is around 75 atom% Mn to 24 atom% Rh or Ir. Furthermore, it is shown that, the minimum value of specific resistance for the MnRh alloy is 58 *µ* Ω · cm and the minimum value of specific resistance for the MnIr is 40 *µ* Ω · cm.

Furthermore, since the Neel temperatures of the Mn-TM alloy and the MnRh alloy are significantly higher than those during actual use, a steady exchange interaction can be attained for the fixed magnetic layer in actual use.

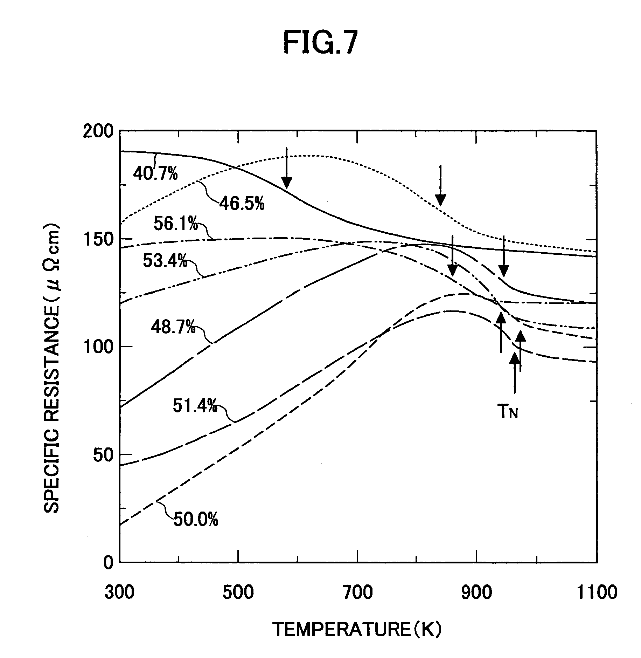

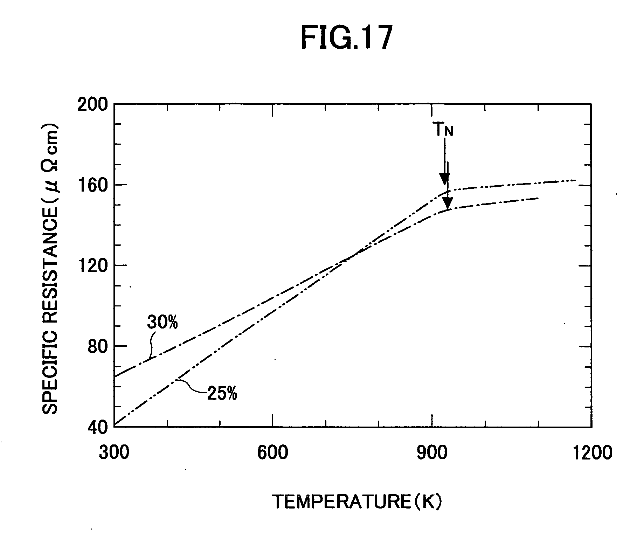

Next, each alloy of the Mn-TM alloy and the MnRh alloy is described in detail with reference to Figs.7 and 17. It is to be noted that the graphs illustrating specific resistance in relation to temperature change is for showing specific resistance illustrating showing specific resistance in cases where temperature is raised and lowered, and the arrows represent Neel temperature T_{N} of each composition. Here, Neel temperature represents a temperature in which the differential value of specific resistance in relation to temperature change is minimum value in a case of a CuAu I type alloy, and represents a temperature in which the gradient of specific resistance in relation to temperature change exhibits an abrupt change in a case of a CuAu II type alloy.

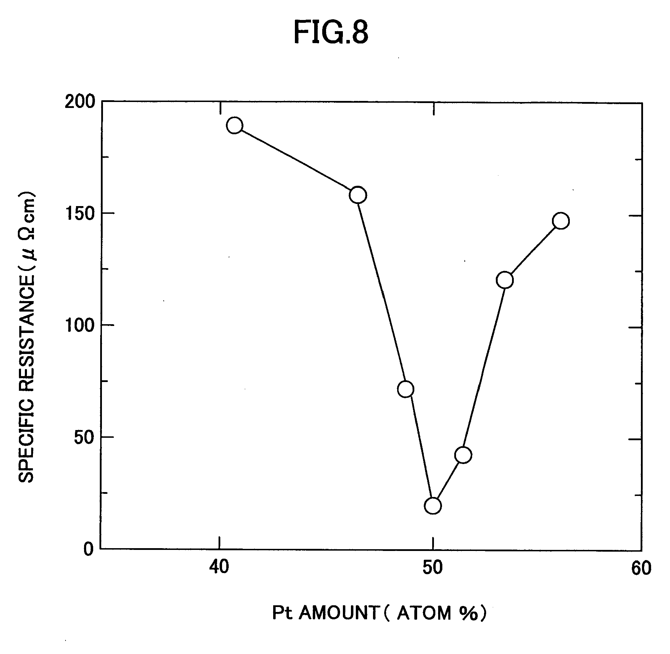

Fig.7 is a drawing showing specific resistance of a MnPt alloy in relation to temperature change. Fig.8 is a drawing showing the relation of the specific relation of a MnPt alloy and its composition in a temperature of 300 K. Figs.7 and 8 show a case where the above-described ordered structure thermal process is performed on a polycrystalline ingot having various compositions in which the amount of Pt in the MnPt alloy is changed in a range from 40.7 atom% to 56.1 atom%.

In Figs.7 and 8, the specific resistance of the MnPt alloy exhibits a minimum value of 22 *µ* Ω · cm. This shows that the specific resistance is significantly reduced compared to a specific resistance of 200 *µ* Ω · cm exhibited by a conventional antiferromagnetic layer. Furthermore, even in a case where the temperature of the thermally processed MnPt alloy is raised to 1100 K, the graph line of specific resistance when temperature is lowered and the graph line of specific resistance when temperature is raised are overlapped. That is, it is shown that the MnPt alloy exhibits satisfactory thermal stability. This shows that the characteristic of low specific resistance does not change even in a case where a thermal process in a magnetic field of 265 °C (538 K) is performed after the ordered structure thermal process.

Furthermore, in Fig.8, the specific resistance of the MnPt alloy in a temperature of 300 K is 150 *µ* Ω · cm or less when the composition of the MnPt alloy has a Pt amount ranging from 46.7 atom% to 56.4 atom% and 75 *µ* Ω · cm or less when the composition of the MnPt alloy has a Pt amount ranging from 48.7 atom% to 52.2 atom%.

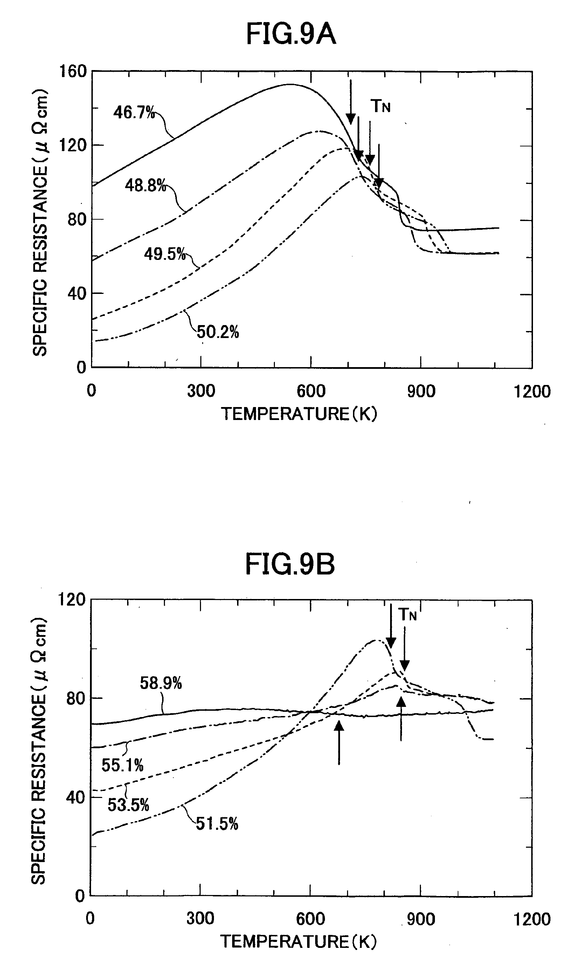

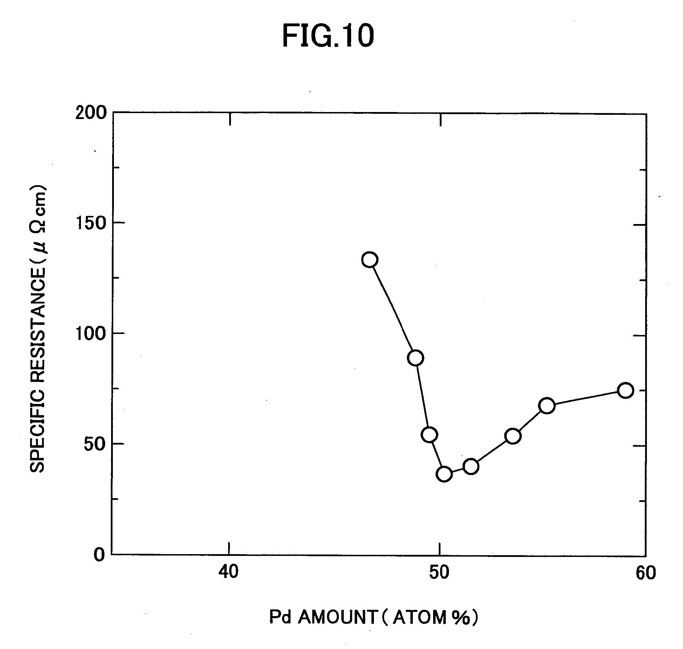

Figs.9A and 9B are drawings showing specific resistance of a MnPd alloy in relation to temperature change. Fig.10 is a drawing showing the relation of the specific relation of a MnPd alloy and its composition in a temperature of 300 K. Figs.9A, 9B and 10 show a case where the above-described ordered structure thermal process is performed on a polycrystalline ingot having various compositions in which the amount of Pd in the MnPd alloy is changed in a range from 46.7 atom% to 58.9 atom%.

Figs.9A and 9B show that the MnPd alloy, being subjected to the ordered structure thermal process, exhibits a significantly reduced specific resistance same as the MnPt alloy. Furthermore, the graph lines of specific resistances of the MnPd alloy are overlapped when temperature is raised/lowered between 4.2 K to 1100 K. Accordingly, same as the MnPt alloy, the MnPd alloy also has a thermally stable characteristic.

Furthermore, in Fig.10, the specific resistance of MnPd in a temperature of 300 K is 150 *µ* Ω · cm or less when the composition of the MnPd alloy has a Pd amount ranging from 46.7 atom% to 58.9 atom% and is 150 *µ* Ω · cm even when the Pd amount is further reduced or increased. Furthermore, the specific resistance of MnPd in a temperature of 300 K is 75 *µ* Ω · cm or less when the composition of the MnPd alloy has a Pd amount ranging from 49.2 atom% to 58.4 atom%.

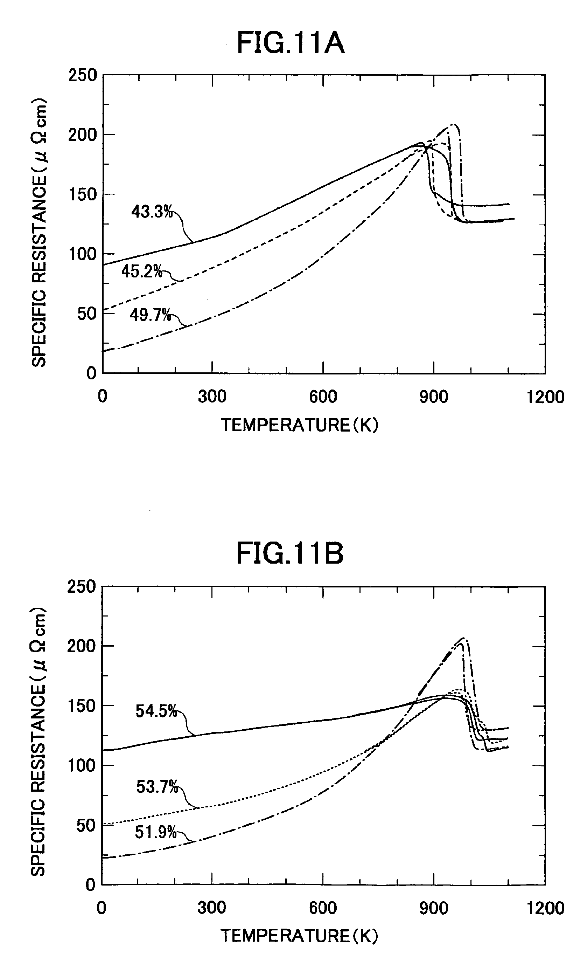

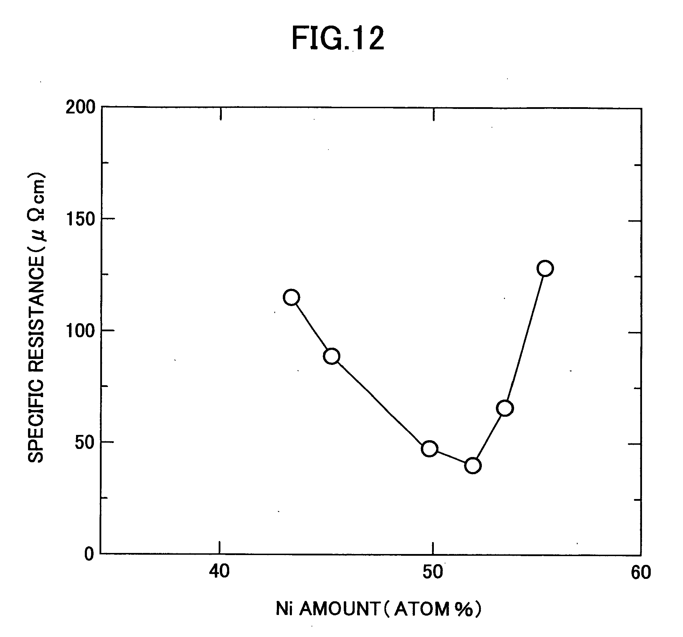

Figs.11A and 11B are drawings showing specific resistance of a MnNi alloy in relation to temperature change. Fig.12 is a drawing showing the relation of the specific relation of a MnNi alloy and its composition in a temperature of 300 K. Figs.11A, 11B and 12 show a case where the above-described ordered structure thermal process is performed on a polycrystalline ingot having various compositions in which the amount of Ni in the MnNi alloy is changed in a range from 43.3 atom% to 54.5 atom%.

Figs.11A and 11B show that the MnNi alloy, being subjected to the ordered structure thermal process, exhibits a significantly reduced specific resistance same as the MnPt alloy. Furthermore, the graph lines of specific resistances of the MnNi alloy are overlapped when temperature is raised/lowered between 4.2 K to 1100 K. Accordingly, same as the MnPt alloy, the MnPd alloy also has a thermally stable characteristic.

Furthermore, in Fig.12, the specific resistance of MnNi in a temperature of 300 K is 150 *µ* Ω · cm or less when the composition of the MnNi alloy has a Ni amount ranging from 43.3 atom% to 54.5 atom% and is 150 *µ* Ω · cm even when the Ni amount is further reduced or increased. Furthermore, the specific resistance of MnNi in a temperature of 300 K is 75 *µ* Ω · cm or less when the composition of the MnNi alloy has a Ni amount ranging from 46.9 atom% to 53.7 atom%.

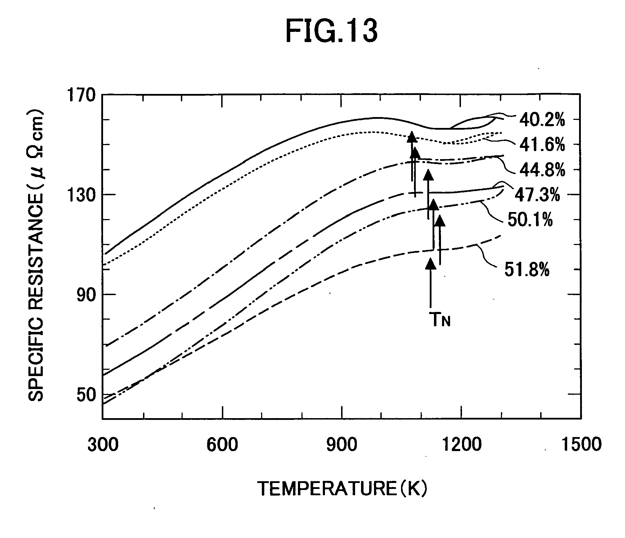

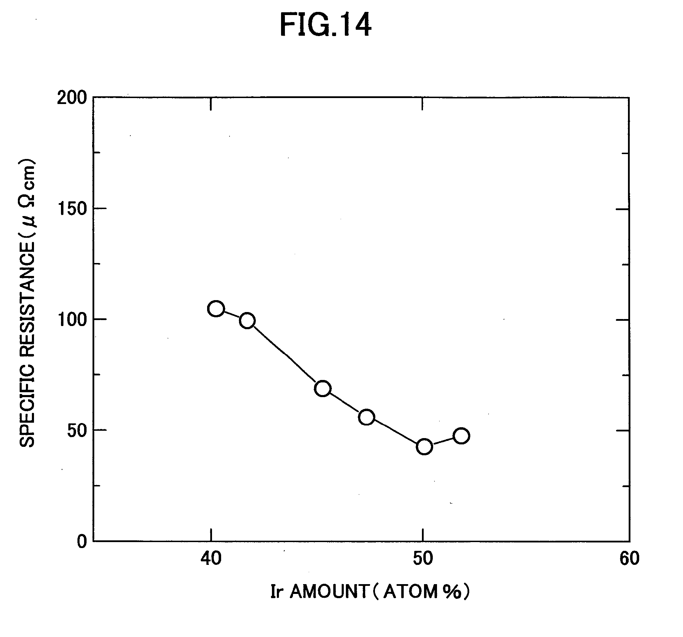

Fig.13 is a drawing showing specific resistance of a MnIr alloy in relation to temperature change. Fig.14 is a drawing showing the relation of the specific relation of a MnIr alloy and its composition in a temperature of 300 K. Figs.13 and 14 show a case where the above-described ordered structure thermal process is performed on a polycrystalline ingot having various compositions in which the amount of Ir in the MnIr alloy is changed in a range from 40.2 atom% to 51.8 atom%.

Fig.13 shows that the MnIr alloy, being subjected to the ordered structure thermal process, exhibits a significantly reduced specific resistance same as the MnPt alloy. Furthermore, the graph lines of specific resistances of the MnIr alloy are overlapped when temperature is raised/lowered between 300 K to 1100 K. Accordingly, same as the MnPt alloy, the MnIr alloy also has a thermally stable characteristic.

Furthermore, in Fig.14, the specific resistance of MnIr in a temperature of 300 K is 150 *µ* Ω · cm or less when the composition of the MnPd alloy has a Ir amount ranging from 40.2 atom% to 51.8 atom% and is 150 *µ* Ω · cm even when the Ir amount is further reduced or increased. Furthermore, the specific resistance of MnIr in a temperature of 300 K is 75 *µ* Ω · cm or less when the composition of the MnIr alloy has a Ir amount no less than 46.5 atom% and is 75 *µ* Ω · cm or less even when the Ir amount is increased to an amount greater than 51.8 atom%.

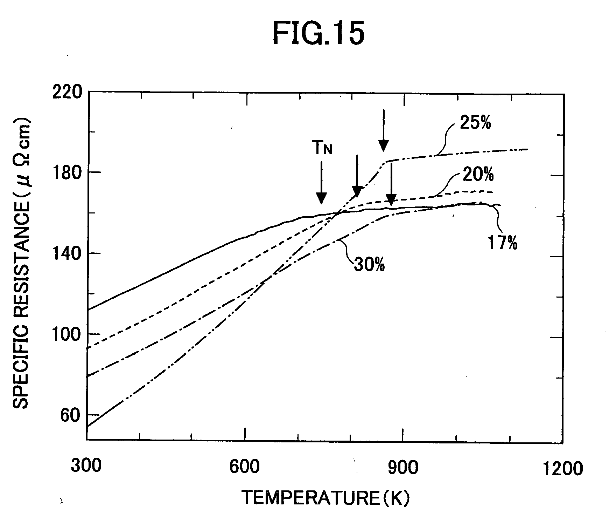

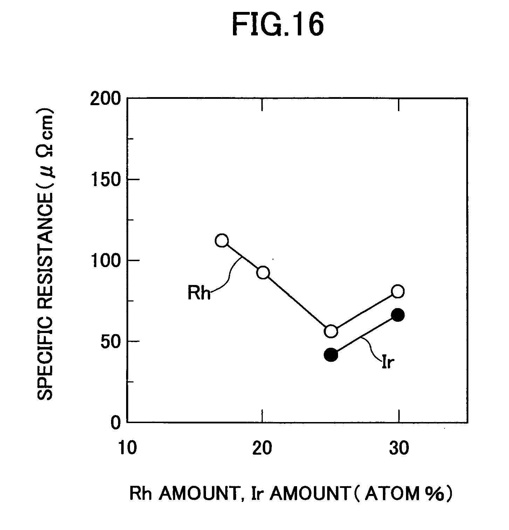

Fig.15 is a drawing showing specific resistance of a MnRh alloy in relation to temperature change. Fig.16 is a drawing showing the relation of the specific relation of a MnRh alloy (also showing a MnIr alloy) and its composition in a temperature of 300 K. Figs.15 and 16 show a case where the above-described ordered structure thermal process is performed on a polycrystalline ingot having various compositions in which the amount of Rh in the MnRh alloy is changed in a range from 17 atom% to 30 atom%.

Fig.15 shows that the MnRh alloy, being subjected to the ordered structure thermal process, exhibits a significantly reduced specific resistance same as the MnPt alloy. Furthermore, the graph lines of specific resistances of the MnRh alloy are overlapped when temperature is raised/lowered between 300 K to 1100 K. Accordingly, same as the MnPt alloy, the MnRh alloy also has a thermally stable characteristic.

Furthermore, in Fig.16, the specific resistance of MnRh in a temperature of 300 K is 150 *µ* Ω · cm or less when the composition of the MnRh alloy has a Rh amount ranging from 17 atom% to 30 atom% and is anticipated to be 150 *µ* Ω · cm even when the Ir amount is further reduced to an amount less than 17 atom% or increased to an amount greater than 30 atom%.

Fig.17 is a drawing showing specific resistance of a MnIr alloy in relation to temperature change. Fig.16 is a drawing showing the relation of the specific relation of a MnIr alloy and its composition in a temperature of 300 K. Figs.16 and 17 show a case where the above-described ordered structure thermal process is performed on a polycrystalline ingot having various compositions in which the amount of Ir in the MnIr alloy is changed in a range from 25 atom% to 30 atom%.

Fig.17 shows that the MnIr alloy, being subjected to the ordered structure thermal process, exhibits a significantly reduced specific resistance same as the MnPt alloy. Furthermore, the graph lines of specific resistances of the MnIr alloy are overlapped when temperature is raised/lowered between 300 K to 1100 K. Accordingly, same as the MnPt alloy, the MnIr alloy also has a thermally stable characteristic.

Furthermore, in Fig.16, the specific resistance of MnIr in a temperature of 300 K is 75 *µ* Ω · cm or less when the composition of the MnIr alloy has a Ir amount of 25 atom% or an amount of 30 atom% and is anticipated to be 75 *µ* Ω · cm or less 150 µΩ · cm or less even when the Ir amount is further reduced from 25 atom% to 20 atom% or increased from 30 atom% to 35 atom%.

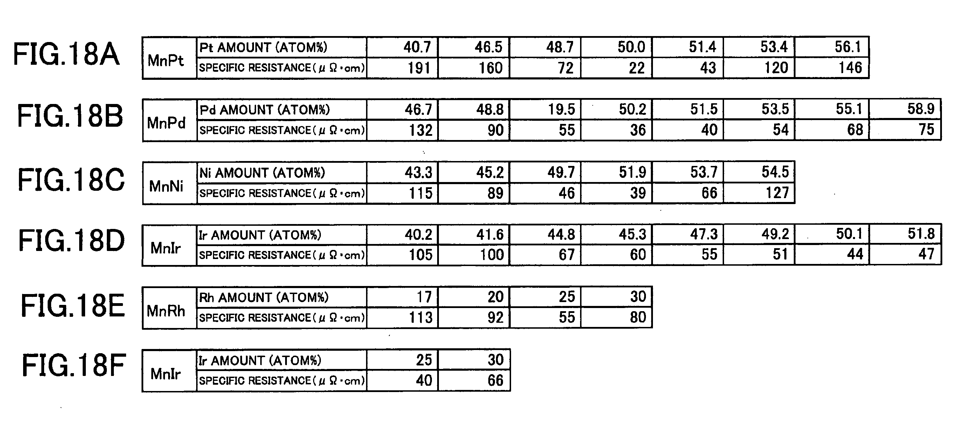

Hence, it is shown that a low specific resistance and a thermally stable characteristic can be attained for the polycrystalline ingots of the alloys of Mn-TM alloy and MnRh alloy being subjected to the ordered structure thermal process. It is to be noted that Figs.18A to 18F showing the figures of the above-described relations between specific resistance and composition of a Mn-TM alloy and a MnRh alloy in a temperature of 300K.

Next, a method of manufacturing a CPP magneto-resistive element, in which the ordered structure thermal process is performed on the foregoing Mn-TM alloy and MnRh alloy, according to an embodiment of the present invention is described.

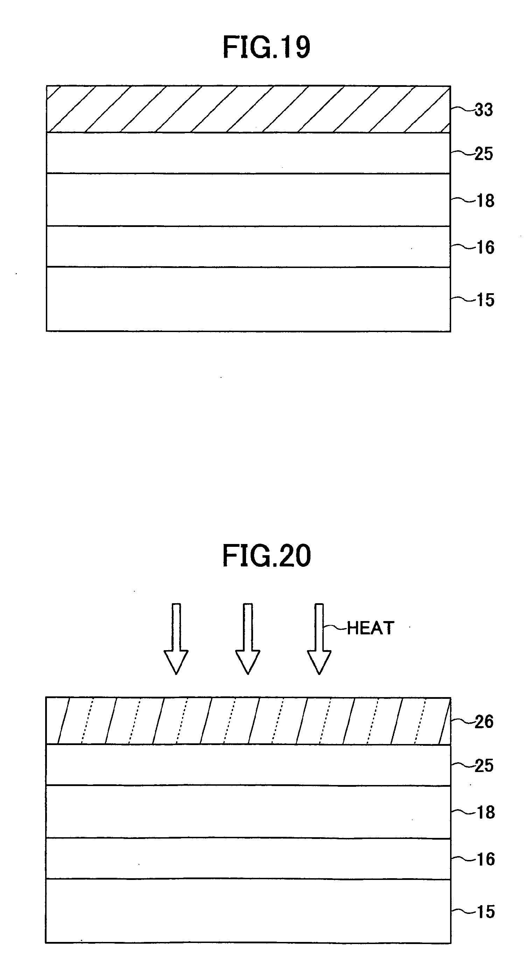

Figs.19 to 24 are diagrams showing processes of manufacturing the magneto-resistive element according to an embodiment of the present invention. The magneto-resistive element is manufactured by employing a method which is substantially similar to a preparatory process for a semiconductor integrated device. The vacuum chamber, which is used for fabricating and thermally processing each layer, is able obtain a base pressure having a vacuum pressure higher than 1 X 10⁻⁸ Pa. For example, a turbo pump may be used as a vacuum exhaust apparatus for maintaining a clean high vacuum atmosphere. Furthermore, the temperature of the substrate during deposition is set to room temperature unless specified in particular.

First, in the step shown in Fig.19, an alumina film 16 is applied on an altic (aluminatitanium carbide) ceramic substrate by employing, for example, a sputtering method. Then, a lower electrode 18 including a NiFe film is formed by employing, for example, a sputtering method or a plating method.

Furthermore, in the step shown in Fig.19, the substrate layer 25, having a Ta film (5 nm thickness) and a NiFe film (5 nm thickness) sequentially layered thereon, is formed on the lower electrode 18 by employing, for example, a sputtering method. The substrate layer 25 is not limited to the above-described materials. It is, however, preferable to use the NiFe film as the upper side layer of the substrate film 25 from the aspect of controlling the direction of crystal growth of the antiferromagnetic layer formed thereon.

Furthermore, in the step shown in Fig.19, the antiferromagnetic layer 33, which includes the above-described Mn-TM alloy (TM = at least one of Pt, Pd, Ni and Ir) or the MnRh alloy and has a thickness of 5 nm to 30 nm (more preferably 10 nm to 20 nm), is formed on the substrate layer 25 by employing, for example, a sputtering method, a vapor deposition method, or a CVD method. In the deposited state, the arrangement of atoms in each of the alloys is not ordered and do not provide an antiferromagnetic property.

Next, in the step shown in Fig.20, the ordered structure thermal process is performed on the configuration shown in Fig.19. The substrate, on which the configuration shown in Fig.19 is formed, is transported from the vacuum chamber (at which the foregoing deposition process is performed) to a thermal processing vacuum chamber while maintaining a highly vacuum state, to thereby perform the ordered structure thermal process by using, for example, a furnace or a RTP (Rapid Thermal Process). This prevents particles and organic matter from adhering to the surface of the antiferromagnetic layer 33 and enables easy etching after the ordered structure thermal process. The thermal processing vacuum chamber which is used is preferably one that can maintain a high vacuum state equal to that of the vacuum chamber used for the deposition process. The ordered structure thermal process may also be performed in the vacuum chamber used for the deposition process.

The ordered structure thermal process is performed under the conditions in which the degree of vacuum is set between 10⁻⁵ Pa to 10⁻³ Pa, the heating temperature is set between 400 2 °C to 800 °C, and the processing time is set between 24 hours to 240 hours. In one example, the ordered structure thermal process is performed under the conditions in which the degree of vacuum is 10⁻⁵ Pa, the heating temperature is 800 °C (1073 K), and the processing time is 72 hours. Furthermore, the rate of temperature rise is 5 °C/minute. The temperature drop is performed by natural cooling in the vacuum chamber (although the rate of the temperature drop may vary depending on temperature, the time of the temperature drop is 8 hours. The ordered structure thermal process may be performed in a state without magnetic field or performed by applying a magnetic field of a subsequent heating process in a magnetic field (by setting the same size and direction). The ordered structure thermal process enables the arrangement of atoms in the antiferromagnetic layer 33 to attain an ordered structure and causes the arrangement of atoms to be distributed even more uniformly. Thus, the antiferromagnetic layer 33 is able to attain a higher ordered structure. As a result, the deposited antiferromagnetic layer 33 is transformed to one having an ordered structure exhibiting the above-described specific resistance values.

Furthermore, in the step shown in Fig.20, the configuration is transported to the vacuum chamber where depositing is performed while maintaining a high vacuum state and has the surface of the antiferromagnetic layer 26 dry etched for activating the uppermost surface thereof. The exchange interaction with the fixed magnetic layer formed on the surface of the antiferromagnetic layer 26 can be prevented from being adversely affected by, for example, slight oxidation of the uppermost surface of the antiferromagnetic layer 26 caused by the ordered structure thermal process. More specifically, the dry-etching is performed by applying, for example, Ar ions or XE ions to the surface of the antiferromagnetic layer 26 and removing one to several atom layers. It is preferable for the energy for applying the ions to range from, for example, 50 eV to 300 eV. This reduces damage of the antiferromagnetic layer 26. The dry-etching may be performed in a vacuum chamber dedicated to dry-etching. The dry-etching process may be omitted.

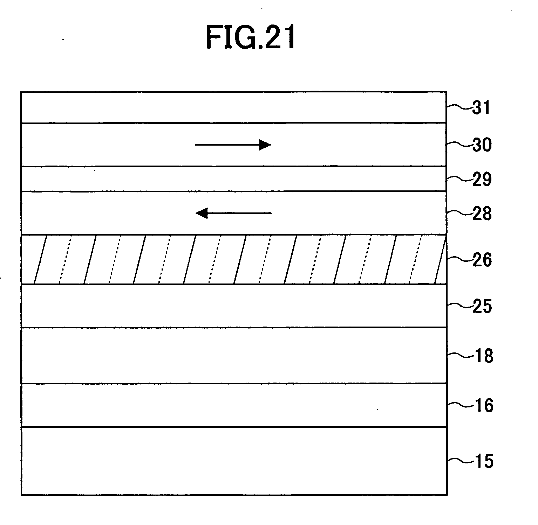

Next, in the step shown in Fig.21, the fixed magnetic layer 28 (Co₉₀Fe₁₀ film (3.0 nm thickness)), the non-magnetic intermediate layer 29 (Cu film (3.0 nm thickness)), the free magnetic layer 30 (Co₉₀Fe₁₀ film (1.5 nm thickness), Ni80Fe20 film (2.1 nm thickness)), and the protective layer 31 (Ta film (5,nm thickness)) are sequentially layered on the activated antiferromagnetic layer 26 by using, for example, a sputtering method.

Furthermore, in the step shown in Fig.21, a heating process is performed in a magnetic field for setting the direction of the uniaxial anisotropy of the antiferromagnetic layer 26, that is, the direction of the magnetization of the fixed magnetic layer. More specifically, the heating process is performed for 10 hours under the conditions in which the size of the magnetic field is set in a range , between 10 kOe to 20 kOe, and the temperature is set in a range between 250 °C to 300 °C.

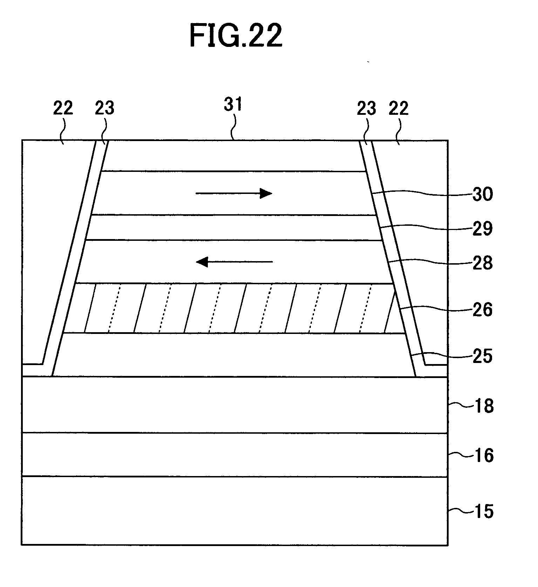

Next, in the step shown in Fig.22, the configuration shown in Fig.21 is subjected to a grinding process to obtain a GMR film 20 having a desired width (corresponding to width of reproduction track). More specifically, in the grinding process, a patterning process using resist film and a dry-etching process are performed until reaching the lower electrode 18.

Furthermore, in the step shown in Fig.22, both sides of the GMR film 20 and the surface of the lower electrode 18 have their surface covered by the insulation film 23 formed of an alumina film. Subsequently, the magnetic domain control films 22 including, for example, CoCrPt are formed. More specifically, apertures are provided at portions where the magnetic domain control films 22 are to be formed by forming resist patterns and the films are depositing by employing, for example, a sputtering method. In this process, the insulation layer 23 including an alumina film, for example, is provided at the interface between the magnetic domain control films 22 and the GMR film 20.

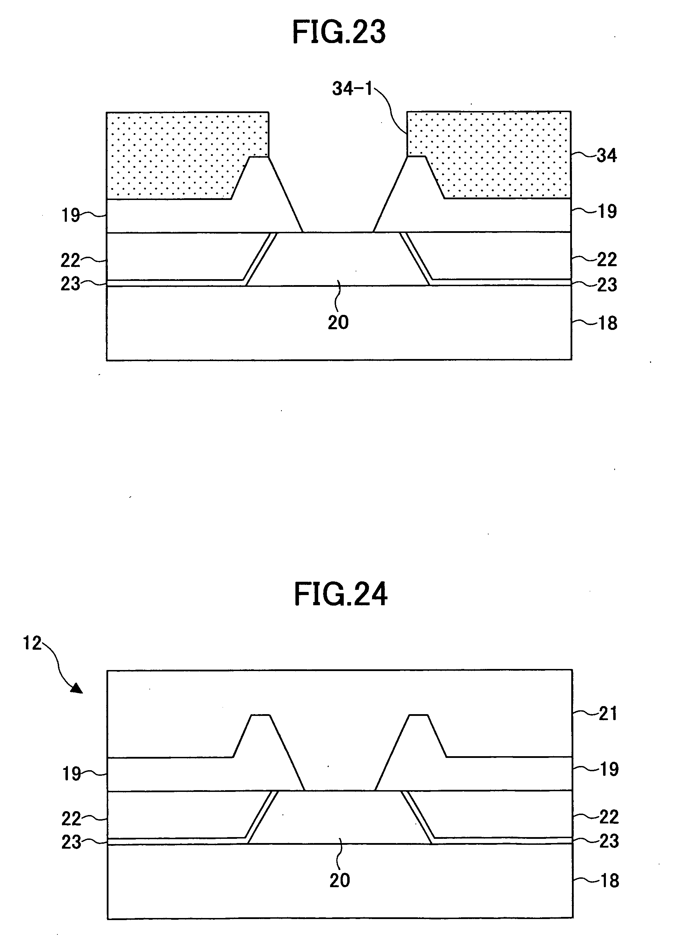

Next, in the step shown in Fig.23, the alumina film 19, which covers the configuration shown in Fig.22, is formed. Then, the alumina film 19 is etched such that a thick part thereof remains above the GMR film 20. Then, a resist film 34 is formed on the alumina film 19 and is patterned for forming an opening part 34-1 above the GMR film 20. Then, a grinding process is performed by employing a RIE (Reactive Ion Etching) method so as to expose the GMR film 20 at the opening part 34-1 of the resist film 34.

Then, in the step shown in Fig.24, the resist film 34 shown in Fig.23 is removed, and the upper electrode 21 including, for example, an NiFe film, is formed by employing a plating method or a sputtering method. Thereby, the forming of the magneto-resistive element 12 is completed. The induction type recording element 11 is formed on the configuration shown in Fig.24 by employing a known method.

In the ordered structure thermal process in the step shown in Fig.20, a thermal process protective layer (e.g. formed of Ta) that is dedicated for the thermal processing may be formed on the surface of the antiferromagnetic layer 26. This protects the surface of the antiferromagnetic layer 26 from, for example, oxidation and allows the thermal process vacuum chamber to be set to a relatively low degree of vacuum so that the apparatus cost for performing the ordered structure thermal process can be reduced. The thermal process protective layer may be removed by dry-etching with an etching gas including SF₆, CF₄, for example.

Hence, according to the above-described embodiment of the present invention, the antiferromagnetic layer 33 is formed and is subjected to the ordered structure thermal process before forming the fixed magnetic layer 28. Thereby, the antiferromagnetic layer 33 changes to the antiferromagnetic layer 26 attaining an ordered structure and a low resistance property. Accordingly, the entire resistance of the GMR film 20 can be reduced. As a result, the change rate of resistance of the magneto-resistive element can be improved. In one example, the antiferromagnetic layer 26 having a thickness of 15 nm and including 50 atom% Mn and 50 atom% Pt is subjected to the ordered structure thermal process for 3 days at a temperature of 800 °C. Then, after the protective layer 31 is formed, the heating process is performed in a magnetic field of 10 kOe for three hours at a temperature of 265 °C. Accordingly, the specific resistance of the antiferromagnetic layer 26 in a temperature of 300 K becomes 22 *µ* Ω · cm. In a case where the characteristics of the conventional GMR film shown in Fig.1 except for the characteristic of the antiferromagnetic layer are applied, the entire resistance RA_{TOTAL} becomes 24.8 mΩ · *µ* m2 and the change rate of resistance improves to 2.4%, which is 2.2 times greater compared to 1.1% of the conventional GMR film shown in Fig.1.

Next, a modified example of the first embodiment of the present invention is described. The configuration of this modified example is the same as that of the first embodiment of the present invention except for a thin layer of a second antiferromagnetic layer provided on the surface of the antiferromagnetic layaer 26 of the GMR film 20.

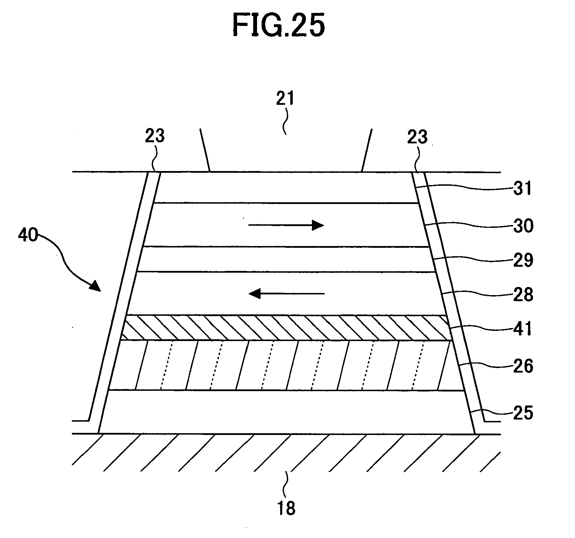

Fig.25 is a diagram showing a GMR film included in the magneto-resistive element according to the modified example of the first embodiment of the present invention. In the drawing, like components are denoted with like numerals as of the foregoing embodiment and are not described in further detail.

In Fig.25, the GMR film 40 has a single spin valve structure having a sequentially layered configuration including a substrate layer 25, a first antiferromagnetic layer 26, a second antiferromagnetic layer 41, a fixed magnetic layer 28, a non-magnetic intermediate layer 29, a free magnetic layer 30, and a protective layer 31. It is to be noted that the antiferromagnetic layer 26 of the first embodiment of the present invention is hereinafter referred to as the first antiferromagnetic layer 26.

The second antiferromagnetic layer 41 is formed on the first antiferromagnetic layer 26. The second antiferromagnetic layer 41 is formed with the same material as the first antiferromagnetic layer 26 and has a thickness of 1 nm to 5 nm.

Next, a method of manufacturing the magneto-resistive element of the modified example is described.

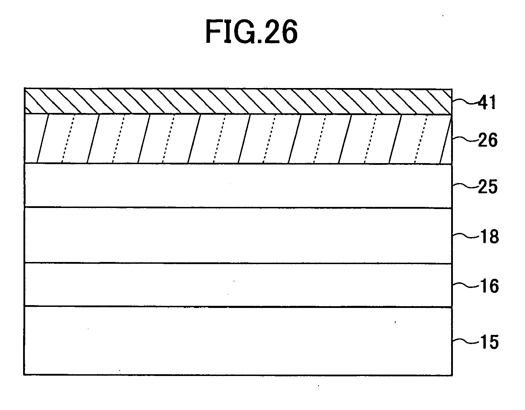

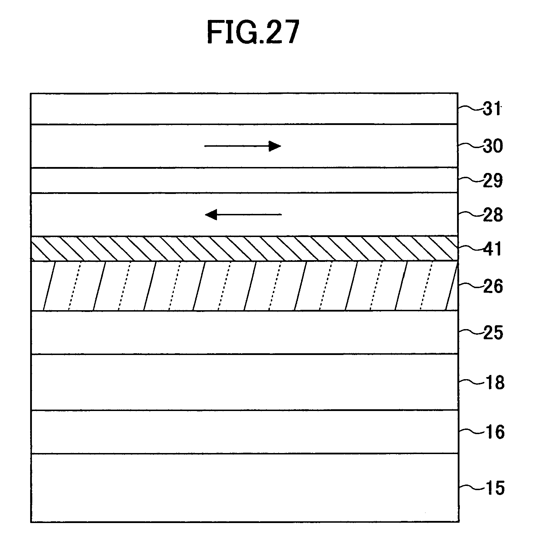

Figs.26 and 27 are diagrams showing a part of the processes of manufacturing the magneto-resistive element of the modified example.

First, the ordered structure thermal process and the etching process are performed in the same manner as the steps of Figs.19 and 20 in the first embodiment of the present invention.

Then, in the step shown in Fig.26, the second antiferromagnetic layer 41 having a thickness of 1 nm to 5 nm is formed on the surface of the first antiferromagnetic layer 26 that is activated by etching. The same material as the first antiferromagnetic layer 26 is used and a sputtering method is employed for forming the second antiferromagnetic layer. Since epitaxial growth of the second antiferromagnetic layer 41 can be realized on the first antiferromagnetic layer 26, the second antiferromagnetic layer 41 can attain an improved crystallinity and a greater exchange interaction with the fixed magnetic layer 28 which is to be formed thereon.

Next, in the step of Fig.27, a layered configuration is formed on the second antiferromagnetic layer 41 from the fixed magnetic layer 28 to the protective layer 31 in the same manner as the first embodiment of the present invention.

Furthermore, in the step of Fig.27, a heating process is performed in a magnetic field for providing antiferromagnetism to the second antiferromagnetic layer 41 and setting the direction of the uniaxial anisotropy of the first and second antiferromagnetic layers 26, 41, that is, the direction of the magnetization of the fixed magnetic layer which is fixed by the exchange interaction with the first and second antiferromagnetic layers 26, 41. More specifically, the heating process is performed for 10 hours under the conditions in which the size of the magnetic field is set in a range between 10 kOe to 20 kOe, and the temperature is set in a range between 250 °C to 300 °C. Then, by further performing the steps shown in Figs.22-24, the forming of the magneto-resistive element of the modified example is completed.

Hence, according to the above-described embodiment of the present invention, the crystal match between the first and second antiferromagnetic layers 26, 41 and the crystal match between the second antiferromagnetic layer 41 and the fixed magnetic layer 28 can be improved by forming the second antiferromagnetic material 41 on the etched first antiferromagnetic layer 26 having the same composition. Thus, the exchange interaction of the first and second antiferromagnetic layers 26, 41 can be improved with respect to the fixed magnetic layer 28. Since the second antiferromagnetic layer 41 is not subjected to the ordered structure thermal process, the specific resistance is the same as that of the conventional antiferromagnetic layer. Nevertheless, the increase of resistance is small owing that the second antiferromagnetic layer 41 is a thin layer. For example, in a case where the second antiferromagnetic layer 41 has a thickness of 2 nm and a specific resistance of 200 *µ* Ω · cm, the resistance of the second antiferromagnetic layer 41 has little effect.

The above-described fixed magnetic layer 28 may have a layered ferri structure. The fixed magnetic layer 28 having the layered ferri structure may have a layered configuration including a lower ferromagnetic layer, a non-magnetic combining layer, an upper ferromagnetic layer. More specifically, the magnetic material of the lower and upper ferromagnetic layers may have the same composition and use a soft magnetic material that is the same as the fixed magnetic layer having a thickness of 1 to 30 nm. The non-magnetic combining layer may have a thickness of, for example, 0.4 nm to 2.0 nm (more preferably, 0.6 nm to 1.0 nm) and include, for example, Ru, Cr, Ru alloy, and Cr alloy. With this configuration, the direction of magnetization of the lower ferromagnetic film is fixed by the exchange interaction of the antiferromagnetic layer 26 provided therebelow, and the magnetization of the upper ferromagnetic film is fixed in a direction anti-parallel to the magnetization of the lower ferromagnetic film since the lower ferromagnetic film is antiferromagnetically combined with the upper ferromagnetic film. By forming a layered ferri structure, the net amount of magnetization of the fixed magnetic layer can be reduced, and the magnetization of the fixed magnetic layer will have less magnetic influence on the free magnetic layer. As a result, the magnetization of the free magnetic layer can accurately respond to the magnetization from outside (e.g. from a magnetic recording medium), and reproduction sensitivity can be improved.

### [Second Embodiment]

The magneto-resistive element having the CPP type structure according to the second embodiment of the present invention uses a TMR (Ferromagnetic Tunnel Junction Magneto Resistive) film as an alternative for the GMR film used in the first embodiment of the present invention. More specifically, an insulating non-magnetic intermediate layer is used as an alternative for the conductive non-magnetic intermediate layer used in the GMR film of the first embodiment of the present invention. This insulating non-magnetic intermediate layer is referred to as a non-magnetic insulation layer.

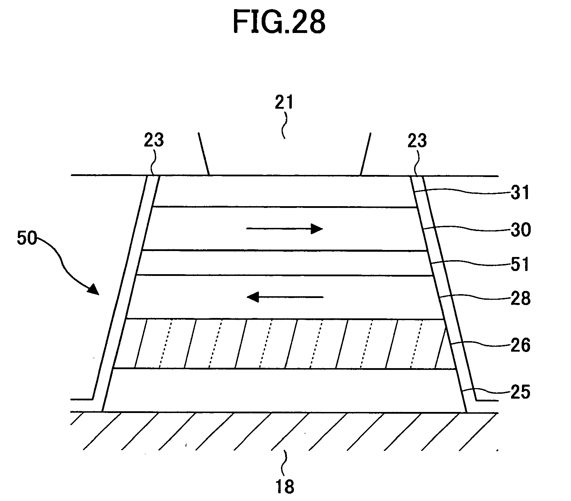

Fig.28 is a drawing showing a TMR film included in the magneto-resistive element according to the second embodiment of the present invention. In the drawing, like components are denoted with like numerals as of the foregoing embodiment and are not described in further detail.

In Fig.28, the TMR film has a configuration which is substantially the same as that of the GMR film shown in Fig.5 and has a sequentially layered configuration including a substrate layer 25, an antiferromagnetic layer 26, a fixed magnetic layer 28, a non-magnetic insulation layer 51, a free magnetic layer 30, and a protective layer 31.

The non-magnetic insulation layer 51 is formed by employing, for example, a sputtering method, and includes, for example, an alumina film, an aluminum nitride film, or a tantalum oxide film having a thickness ranging from 0.5 nm to 1.5 nm. These materials may be directly deposited. Alternatively, a metal film (e.g. aluminum film) may be formed and then transformed by employing a natural oxidation method, a plasma oxidation method, or a radical oxidation method or a nitriding method thereof.

The antiferromagnetic layer 26 may be the antiferromagnetic layer of the first embodiment of the present invention or the layered configuration including the first and second antiferromagnetic layers of the modified example of the first embodiment of the present invention. Accordingly, as described above, specific resistance can be reduced and result in reduction of resistance.

The resistance of the antiferromagnetic layer 26 in the TMR film 50 is a small proportion compared to that of the GMR film owing to the high resistance of the ferromagnetic tunnel junction part including the fixed magnetic layer 28, the non-magnetic insulation layer 51, and the free magnetic layer 30. Nevertheless, the resistance of the antiferromagnetic layer 26 is still parasitic resistance. Thus, the change rate of resistance of the TMR film can be improved by reducing the specific resistance of the antiferromagnetic layer 26. Thereby, a magneto-resistive element, which is suitable for high sensitivity and high density recording, can be obtained.

### [Third Embodiment]

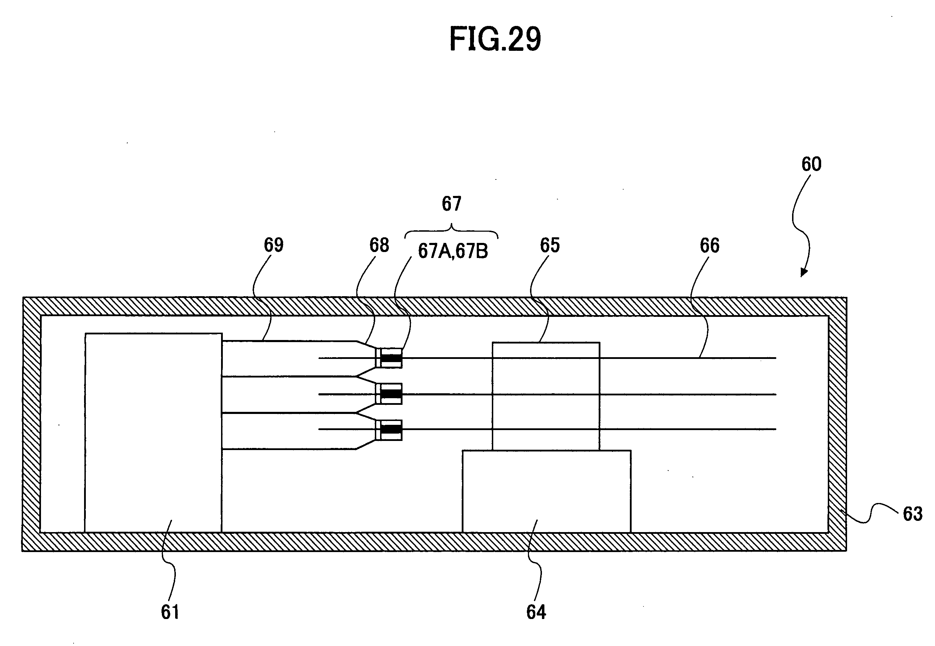

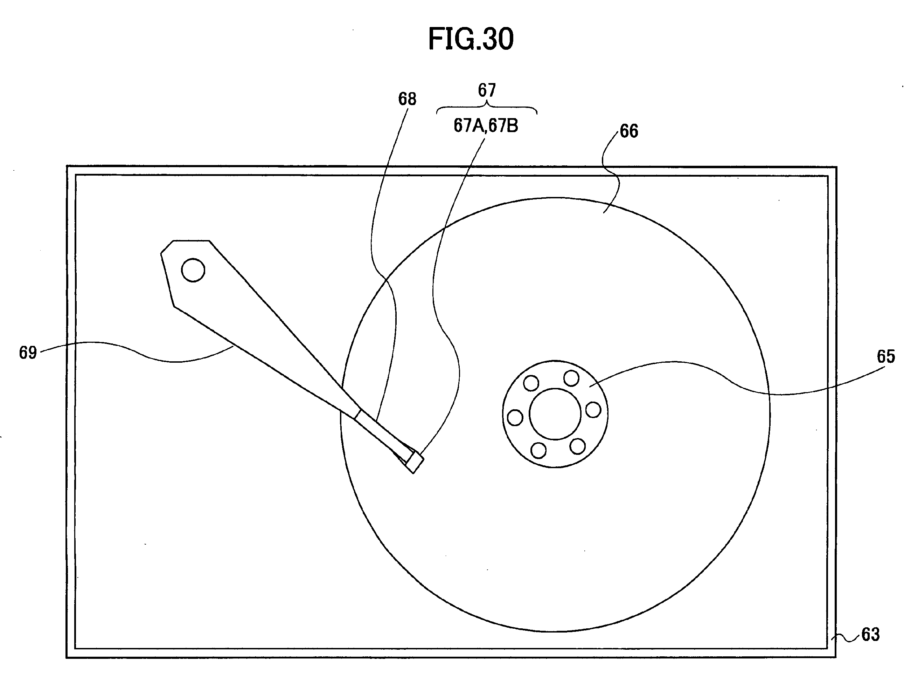

Next, a magnetic memory apparatus according to the third embodiment of the present invention is described with reference to Figs.29 and 30. Fig.29 is a cross-sectional view showing a main part of the magnetic memory apparatus. Fig.30 is a plan view showing the main part of the magnetic memory apparatus shown in Fig.29.

In Figs.29 and 30, a magnetic memory apparatus 60 includes a housing 63. A motor 64, a hub 65, plural magnetic recording media 66, plural complex type magnetic heads 67, plural suspensions 68, plural arms 69, and an actuator unit 61 are provided in the housing 63. The magnetic recording media 66 are attached to the hubs 65 that are rotated by the motor 64. The complex type magnetic heads 67 include an induction type recording element 67A and a magneto-resistive element 67B (not shown owing to its fine size). Each complex type magnetic head 67 is attached to a distal end of a corresponding arm 69 via the suspension 68. The arms 69 are driven by the actuator unit 61. The basic configuration of the magnetic memory apparatus is relatively known and a detail description thereof is omitted.

One characteristic of the magnetic memory apparatus 60 according to this embodiment of the present invention is the magneto-resistive element 67B. The magneto-resistive element 67B is the magneto-resistive element used in the first embodiment, the modified example of the first embodiment, and the second embodiment. As described above, the magneto-resistive element has a high resistance change rate, that is, a high sensitivity for detecting a magnetic field. Accordingly, the magnetic memory apparatus 60 has high recording performance and is suitable for high density recording given that reading can be achieved even in a case where only a slight magnetic field emanates from a single reversed magnetic domain corresponding to a single bit of information.

Further, the present invention is not limited to these embodiments, but variations and modifications may be made without departing from the scope of the present invention.

For example, although an example of providing the layered ferri structure in fixed magnetic layer is described in the foregoing embodiments, the layered ferri structure may be provided in the free magnetic layer, or in both the fixed magnetic layer and the free magnetic layer.

Although a hard disk apparatus is described as an example of the magnetic memory apparatus in the foregoing embodiments, the present invention is not limited to a hard disk apparatus. For example, the present invention may be applied to a magnetic head used for a magnetic tape apparatus such as a helical scanning type video tape apparatus or a complex type magnetic head used for a computer-use magnetic tape having a large number of tracks in a width direction of the magnetic tape.

### [Industrial Applicability]

With the present invention, the resistance of parasitic resistance can be reduced and the resistance change rate can be improved by reducing the specific resistance of the antiferromagnetic layer. Thus, there is provided a CPP magneto-resistive element, which has high sensitivity and is suitable for high density recording, a method for manufacturing the CPP magneto-resistive element, and a magnetic head and a magnetic memory apparatus including the CPP magneto-resistive element.

## Claims

1. A CPP magneto-resistive element **characterized by** comprising:
a substrate; and
an antiferromagnetic layer, a fixed magnetic layer, a non-magnetic intermediate layer, and a free magnetic layer that are sequentially formed on the substrate;
wherein the antiferromagnetic layer includes an alloy of Mn and at least one element of a group including Pd, Pt, Ni, Ir, and Rh;
wherein the specific resistance of the antiferromagnetic layer ranges from 10 *µ* Ω · cm to 150 µΩ · cm at a temperature of 300K.

2. The CPP magneto-resistive element as claimed in claim 1, **characterized in that** the specific resistance of the antiferromagnetic layer ranges from 10 *µ* Ω · cm to 75 *µ* Ω · cm at a temperature of 300K.

3. The CPP magneto-resistive element as claimed in claim 1, **characterized in that** the antiferromagnetic layer has a crystal structure including a CuAu I type ordered structure.

4. The CPP magneto-resistive element as claimed in claim 1, **characterized in that** the antiferromagnetic layer includes an alloy of Mn and at least one element of a group including Pd, Pt, Ni, and Ir, wherein the Mn content of the antiferromagnetic layer ranges from 45 atom% to 52 atom%.

5. The CPP magneto-resistive element as claimed in claim 1, **characterized in that** the antiferromagnetic layer includes an alloy of Mn and at least two elements of a group including Pt, Pd, Ni, and Ir.

6. The CPP magneto-resistive element as claimed in claim 1, **characterized in that** the antiferromagnetic layer includes MnRh, wherein the Rh content ranges from 15 atom% to 30 atom%.

7. The CPP magneto-resistive element as claimed in claim 6, **characterized in that** the MnRh has a crystal structure including a CuAu II type ordered structure.

8. The CPP magneto-resistive element as claimed in claim 6, **characterized in that** the Rh content of the antiferromagnetic layer ranges from 23 atom% to 27 atom%.

9. The CPP magneto-resistive element as claimed in claim 1, **characterized in that** the antiferromagnetic layer includes MnIr, wherein the Ir content ranges from 20 atom% to 35 atom%.

10. The CPP magneto-resistive element as claimed in claim 9, **characterized in that** the MnIr has a crystal structure including a CuAu II type ordered structure.

11. The CPP magneto-resistive element as claimed in claim 1, further **characterized by** comprising another antiferromagnetic layer provided between the antiferromagnetic layer and the fixed magnetic layer, wherein the other antiferromagnetic layer includes the same materials as the antiferromagnetic layer and has a specific resistance higher than that of the antiferromagnetic layer.

12. The CPP magneto-resistive element as claimed in claim 1, **characterized in that** the non-magnetic intermediate layer includes a conductive material or an insulating material.

13. The CPP magneto-resistive element as claimed in claim 1, **characterized in that** at least one of the free magnetic layer and the fixed magnetic layer has a layered ferri structure including two ferromagnetic layers and a non-magnetic combining layer interposed between the ferromagnetic layers.

14. A magnetic head **characterized by** comprising:
the CPP magneto-resistive element as claimed in claim 1.

15. A magnetic memory apparatus **characterized by** comprising:
the magnetic head as claimed in claim 14; and
a magnetic recording medium.

16. A method of manufacturing a CPP magneto-resistive element including a substrate, and an antiferromagnetic layer, a fixed magnetic layer, a non-magnetic intermediate layer, and a free magnetic layer that are sequentially formed on the substrate, the method **characterized by** comprising the steps of:
forming the antiferromagnetic layer on the substrate;
forming the fixed magnetic layer on the antiferromagnetic layer; and
executing an ordered structure thermal process by heating the antiferromagnetic layer and forming the antiferromagnetic layer into an ordered structure between the step of forming the antiferromagnetic layer and the step of forming the fixed magnetic layer.

17. The method of manufacturing a CPP magneto-resistive element as claimed in claim 16, **characterized in that** the heating temperature ranges from 400 °C to 800 °C and the heating time ranges from 24 hours to 240 hours in the step of executing the ordered structure thermal process.

18. The method of manufacturing a CPP magneto-resistive element as claimed in claim 16, further **characterized by** comprising a step of etching the surface of the antiferromagnetic layer between the step of executing the ordered structure thermal process and the step of forming the fixed magnetic layer.

19. The method of manufacturing a CPP magneto-resistive element as claimed in claim 18, further **characterized by** comprising a step of forming another antiferromagnetic layer, which includes the same materials as the antiferromagnetic layer, on the antiferromagnetic layer after the etching step.

20. The method of manufacturing a CPP magneto-resistive element as claimed in claim 16, further **characterized by** comprising a step of forming an ordered structure thermal process protective layer, which covers the antiferromagnetic layer, between the step of forming the antiferromagnetic layer and the step of executing the ordered structure thermal process.
